# EUROPEAN PATENT APPLICATION

(11) **EP 1 968 360 A1**
(43) Date of publication of application: **10.09.2008**
(21) Application number: 07103774.1
(22) Date of filing: 08.03.2007
(51) Int. Cl.: H05K 1/02

(54) **Method for manufacturing flexible printed circuitry**

(71) Applicant: IEE INTERNATIONAL ELECTRONICS & ENGINEERING S.A., 6468 Echternach (LU)
(72) Inventor: Maoujoud, Mohammed, 2619 Luxembourg (LU)
(74) Representative: Ocvirk, Philippe

(57) **Abstract**

Method for manufacturing a flexible printed circuit (10) is disclosed, wherein a conductor circuit pattern (12) is formed on a flexible dielectric substrate (14). The flexible printed circuit is reinforced by applying lines and/or shapes of flexible dielectric material (16) over the substrate (14) at predetermined locations so that they are located between the elements (12) of the circuit pattern, the flexible dielectric material (16) having a greater elasticity than that of said circuit pattern (12).

## Description

### TECHNICAL FIELD

The present invention generally relates to the manufacturing of flexible printed circuitry.

### BACKGROUND ART

Flexible printed circuitry (FPC) can be generally defined as a patterned array of conductors supported by a flexible dielectric film made of polymer material such as e.g. polyimide. The flexibility of FPC provides *inter alia* an opportunity for three dimensional packaging, easy interconnections and dynamic applications. The polymeric support layer is the primary load bearing structure when the substrate is not supported by a rigid plate. In its composite structure, the conductive lines or shapes, that may be conventionally manufactured by printing technique using polymer ink with silver particles, are more vulnerable to failure due to their typically lower flexibility compared to the support layer.

An example of dynamic application using flexible printed circuitry is that of seat occupancy sensors conventionally used in automobile vehicles for detecting the presence and/or the position of an object or passenger in a seat, in order to permit occupancy classifying by type or nature and provide an occupancy state or condition signal for use with a safety restraint system control of e.g. an airbag. Such seat occupancy sensor typically comprises a plurality of pressure sensitive cells distributed over the surface of the seat. The pressure sensitive cells comprise pressure sensitive resistors, i.e. the resistance of these pressure sensors changes with the pressure applied on the sensor. The reading of the resistance values of the individual pressure sensors thus gives an indication on the pressure acting on each cell and accordingly can be related to the weight acting on the seat. Furthermore the distribution of the pressure values over the surface of the seat can be related to the size or the form of a person or an object occupying the seat.

The pressure sensitive resistors of the occupancy sensor usually take the form of foil-type pressure sensors with two supporting foils, which are sandwiched by means of a spacer. Two electrode structures are arranged on the supporting foils, which are contacted through a pressure sensitive layer if the sensor is activated, so that the electrical resistance of the sensor decreases with increasing pressure. Today such sensors are conventionally manufactured using printing techniques: the conductor lines and electrodes can be printed on the substrate.

When the seat occupancy sensor is installed in a car seat, it is subjected to considerable bending efforts that can lead to the rupture of conductive elements. It would thus be desirable to increase the lifetime of such sensors and more generally of flexible circuitry.

### GENERAL DESCRIPTION OF THE INVENTION

In order to increase the lifetime of flexible circuitry, the present invention proposes to provide reinforcement in the form of lines or shapes of flexible dielectric material that are provided on the flexible substrate next to the conductors of the circuit pattern, the dielectric material having a greater elasticity than the material constitutive of the circuit pattern.

The present invention thus relies on the principle that the energy that is absorbed by the flexible dielectric material does not need be absorbed by the conductor lines of the circuit pattern, thereby reducing the risk of rupture of the conductor lines due to bending/folding and thus constituting a form of reinforcement. In other words, the proposed design lowers the probability of the conductor lines to break in the field and thus increases the chance of surviving the mechanical stresses-such as folding and compressive bending-that the flexible circuit undergoes during its lifetime.

It shall be appreciated that in a quite surprising manner, the present invention provides reinforcement of the circuit lines to folding and bending without involving the addition of more rigid material, since the dielectric material that is added is of high elasticity.

Another practical aspect of the invention is the isolation of conductive lines to avoid short-circuits, depending on the design.

The dielectric material to be used as reinforcement material according to the invention may be a polymeric material such as copolymer polyvinylidene chloride acrylonitrile (PVDC-AN), polyimide PI, or the like. The Young Modulus, also called elasticity modulus (Emod), for the polymer PI ranges between 1300 and 4000 MPa. While for PVDC copolymer, the typical values of EMod are typically in the range of 345 to 552 MPa. As is well known, the lower the elasticity modulus, the greater the flexibility of the material.

Materials without a yield point (i.e. no plastic deformation) and having a low Emod behave like rubber. They are highly stretchable. Note that the elongation at break of PI is around 90%, while for PVDC it varies from 160 to 240%.

Generally the dielectric material to be used in the present invention may be a highly flexible polymer, preferably having a Young's modulus no greater than that of the carrier/substrate. Preferably, the elasticity modulus should be much below the one of the carrier/substrate.

Depending on the kind of flexible circuitry, the reinforcement in accordance with the present invention may take several forms.

According to one aspect of the invention, a method for manufacturing a flexible printed circuit is proposed, wherein a conductor circuit pattern is formed on a flexible dielectric substrate. The flexible circuit is reinforced by applying lines and/or shapes of flexible dielectric material over the substrate at predetermined locations so that they are located between the elements of the circuit pattern (i.e. conductor lines or pads, or other conductor shapes), the flexible dielectric material having a greater elasticity than that of said circuit pattern. The method thus provides an easy way of reinforcing flexible printed circuits.

The term flexible printed circuit means herein any type of electrically conductive lines or shapes that are fixed on a flexible substrate, regardless of the production method of the conductive lines or shapes. Hence, the conductor pattern can be manufactured by any appropriate method such as mechanical or chemical etching, photolithography, etc. However, the present method is particularly convenient for use with printing techniques, namely screen, inkjet, flexo, gravure or offset printing.

In one embodiment, the flexible dielectric material is printed on the substrate by a technique such as: screen, inkjet, flexo, gravure or offset printing. This is a simple and rapid way to provide reinforcement of the circuit lines. It is of course advantageous and very convenient to implement when the conductive lines are also formed by such printing technique. The conductive and dielectric lines can be formed simultaneously or successively.

The lines and/or shapes of flexible dielectric material that are formed on the substrate may have a height that is lower, equal or greater than the conductor circuit pattern.

In another embodiment, the flexible dielectric material is laminated over the substrate as a foil or sheet of dielectric material, the side of the foil or sheet facing the substrate having recesses corresponding to the location of the circuit pattern.

The nature of the substrate may depend on the application of the sensor. In the case of foil type switches, the substrate may typically be a polymeric support layer (e.g. polyimide-PI, Polyethylene terephthalate -PET and like materials). In other applications, the substrate may be a textile foil. Both polymeric and textile substrates are compatible with printing techniques.

If desired, an insulating layer may be formed over the substrate, circuit pattern and flexible dielectric material to provide an external coating.

According to another aspect of the invention, a flexible printed circuit comprises a substrate with a conductor circuit pattern and is characterized by lines and/or shapes of flexible dielectric material over the substrate at predetermined locations between the elements of the circuit pattern (i.e. conductor lines or pads, or other conductor shapes), the flexible dielectric material having a greater elasticity than the circuit pattern.

According to a further aspect of the present invention, there is proposed a method for manufacturing a flexible electrode, wherein a pad of conductive material and of desired shape is formed on a substrate. The pad is reinforced by forming lines and/or shapes of flexible dielectric material at predetermined locations on the substrate and/or on the pad, the flexible dielectric material having a greater elasticity than said conductive pad. This method thus concerns the manufacture of reinforced flexible electrodes that may be required in some electrical devices, e.g. in capacitive sensors where large area electrodes are required.

In one embodiment, the dielectric material lines or shapes are formed preferably by printing on the substrate. The electrode pad may then be formed over the substrate area to cover the dielectric material reinforcement. This design provides a dielectric material reinforcement that is embedded in the conductive pad.

Alternatively, the dielectric material can be arranged on the substrate in such a way that it forms predetermined shapes or lines locally interrupting the conductive material. This can be done by first forming the lines and/or shapes of dielectric material and then depositing the conductive material to form the desired pad. Another possibility may be to form an uninterrupted pad on the substrate and to remove material down to the underlying substrate at selected regions where the dielectric reinforcement material is to be arranged. This removal can be done by any appropriate method, e.g. involving mechanical or chemical etching.

In another embodiment, a continuous electrode pad is formed on the substrate and lines and/or shapes of dielectric material are formed on the free surface of the electrode pad (opposite the substrate). Distinct lines and or shapes of dielectric material that are arranged over a cumulative area smaller than that of said pad act as reinforcing ridges.

### BRIEF DESCRIPTION OF THE DRAWINGS

The present invention will be more apparent from the following description of several not limiting embodiments with reference to the attached drawings, wherein:
FIGS. 1 to 3: illustrate section views through three different embodiments of a flexible printed circuit in accordance with the invention;
FIGS. 4 to 6: illustrate section views through three different embodiments of a flexible electrode in accordance with the invention;
FIG.7: shows one side of a membrane switch having a reinforced electrode design;
FIG.8: is a top view of the flexible printed circuit of Fig.2;
FIGS. 9 and 10: are top views of the flexible electrodes of FIGS. 4 and 5, respectively.

### DETAILED DESCRIPTION OF PREFERRED EMBODIMENTS

The present invention proposes a micro-fortress design using highly flexible dielectric material to reinforce flexible circuit patterns or flexible electrodes. Separate lines and/or shapes of dielectric material are provided between conductor lines or other elements of the circuit pattern to provide reinforcement against mechanical stresses generated by folding and bending, providing enhanced ruggedness. As can be seen from the FIGS. a variety of arbitrary shapes are possible for reinforcement with dielectric material. It is also possible to completely fill the space between the conductive lines on the substrate.

It may be noted that in the following embodiments, improved resistance to conductor line cracks is obtained with the use highly flexible material.

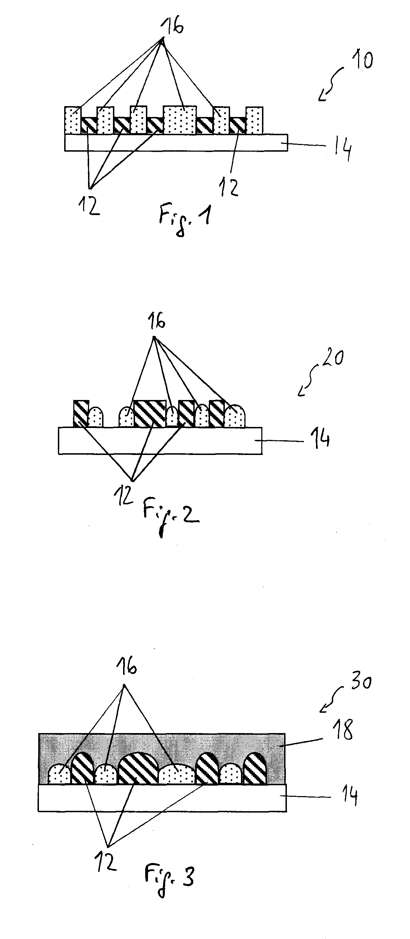

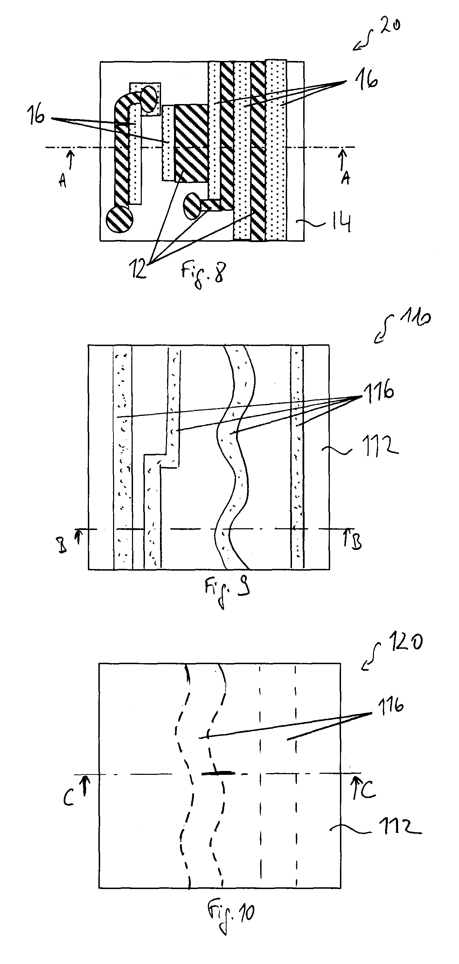

Figs. 1 to 3 and 8 illustrate three embodiments of a flexible circuit 10, 20 and 30 respectively, in accordance with the invention. Fig.2 is a section view along line A-A of the flexible printed circuit of Fig.8. In each Fig., reference sign 12 indicates conductor lines of a circuit pattern formed on a polyimide foil forming a flexible substrate 14. The conductor lines 12 are preferably printed on the substrate 14 and may thus consist of e.g. silver ink or electrically conductive polymer. Reinforcement against mechanical stresses is provided by lines 16 of highly flexible dielectric material contiguous to the conductor lines 12.

In Fig.1 the dielectric material lines 16 are higher than the conductor lines 12, whereas in Fig.2 the dielectric material lines 16 are of same or smaller height than the conductor lines 12.

In Fig.3, the flexible circuit with conductor lines and reinforcing dielectric material lines 16 is covered by an insulating foil 18, which can be provided in a conventional manner to electrically insulate the circuit.

As mentioned above, the substrate layer 14 may be a polyimide foil, or consist of any other appropriate polymeric material such as: polyetherimide-PEI (Ultem® by General Electric), Polyethylene terephthalate -PET, Polyethylene naphtalate-PEN, etc.

When manufactured by printing techniques, the conductor lines 12 may consist of silver ink or conductive polymer, namely Poly(3,4-ethylenedioxythiophene)-poly(styrenesulfonate)-PEDOT:PSS, polyaniline, polypyrrole, polythiophene, etc.

As for reinforcing lines and shapes 16, highly flexible dielectric material is particularly preferred. Thermoplastic polymers such as those used for the substrate (e.g. PI, PET, PEN...) may be used for compatibility reasons (adhesion, wettability, etc.). More preferred polymers are pure polymers use to make the printable inks like PVDC-AN, phenoxy resin or a phenoxy resin cross-linked with a phenolic one. A typical ratio for the latter system is 3 : 1 (3 for phenoxy resin) or preferably higher.

It shall be kept in mind that charging highly elastic materials with metallic or non-metallic particles causes stiffening of the materials; therefore their mechanical performances such as flexibility, degrade. Flexible dielectric materials to be used herein shall preferably have a Young's modulus below the one of the substrate.

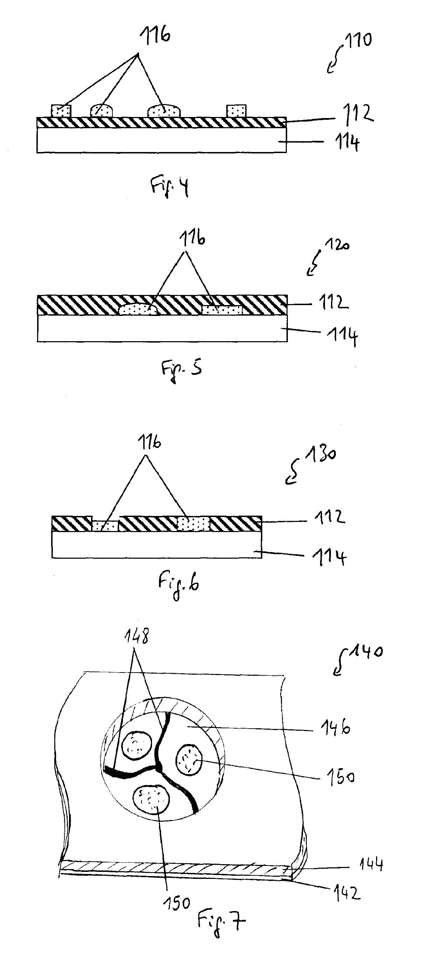

Turning now to Figs.4 to 6, there are represented three embodiments 110, 120, 130 of flexible electrodes. Such design is suitable for the manufacture of electrodes having a size greater than electrodes used in printed circuits that simply form contact pads, typically above one square cm.

It may be noted that Figs.4 and 5 illustrate section views through the flexible electrodes shown in Figs. 9 and 10 respectively.

In these Figs, reference sign 112 indicates a conductor pad of desired shaped on a flexible substrate 114. Reinforcement against mechanical stresses is provided by separate lines or shapes 116 of highly flexible dielectric material.

In the embodiment of Fig.4, the reinforcing dielectric material 116 is provided on top of the electrode pad 112, acting as reinforcing ridges.

The conductor pad 112 may consist of metal deposited on the substrate by any appropriate method (e.g. chemical deposition, electroless plating combined with galvanic reinforcement), lamination of a metal foil, or of conductive polymer or conductive paste with metallic compounds that may be deposited by printing techniques.

In the embodiment of Fig.5, the lines/shapes of dielectric material 116 are embedded in the electrode pad 116. This can be done by forming, e.g. printing, the dielectric material 116 on the substrate 114 and subsequently forming the conductive pad 112 thereon.

In the embodiment of Fig.6 the conductive pad 112 is first formed on the substrate 114 by any appropriate method as mentioned e.g. in connection with the embodiment of Fig.4. Next conductive pad material is removed at selected locations down to the underlying substrate 114, and the grooves are filled with flexible dielectric material to form the desired reinforcing lines or shapes 116.

It remains to be noted that the present invention will help reinforcing cells of membrane switches having a particular conductive pattern, for example in the case of electrodes comprising vortex-type, very narrow conductive or resistive lines (as e.g. described in WO 02/097838).

Fig.7 partially illustrates such a membrane switch 140 (foil type switching element) that comprises a pair of flexible carrier foils 142 (only the lower foil is illustrated in Fig.7) separated by a spacer 144 having an opening therein defining an active area 146. Electrodes are arranged on each carrier foil 142 in the active area 146 so that they face each other and can be pressed toward each other by acting on the switch.

As can be seen in Fig.7, the electrode arranged on the lower carrier foil consists of narrow conductive strips 148. In order to reinforce such structure, shapes (disks or squares) of dielectric material 150 are advantageously arranged in between these conductive strips. Alternatively, the space between the conductive electrode lines could be completely filled with dielectric material. As it will be understood, in order not to hinder the contacting between facing electrodes, the height of the dielectric material should preferably not be greater than that of the conductive electrodes.

It is to be further appreciated that the above design does not only provide reinforcement against mechanical bending but also acts as shock absorber. In other words, this design provides reinforcement against electrode line brakes but also minimises conductive ink abrasion problems in the cell.

## Claims

1. A method for manufacturing a flexible printed circuit, wherein a conductor circuit pattern is formed on a flexible dielectric substrate, **characterized in that** the flexible printed circuit is reinforced by applying lines and/or shapes of flexible dielectric material over the substrate at predetermined locations so that they are located between the elements of the circuit pattern, said flexible dielectric material having a greater elasticity than that of said circuit pattern.

2. The method according to claim 1, wherein said flexible dielectric material is printed on said substrate by a printing technique such as screen, inkjet, flexo, gravure or offset printing.

3. The method according to claim 1 or 2, wherein said lines and/or shapes of flexible dielectric material printed on said substrate have a height that is lower, equal or greater than said conductor circuit pattern.

4. The method according to claim 1, wherein said flexible dielectric material is laminated over said substrate as a foil or sheet of dielectric material, the side of which to face the substrate having recesses corresponding to the location of the circuit pattern.

5. The method according to any one of the preceding claims, wherein said conductor circuit pattern is formed by a printing technique, such as screen, inkjet, flexo, gravure or offset printing; or by a technique involving mechanical or chemical etching.

6. The method according to any one of the preceding claims, wherein an outer insulating coating layer is formed over said substrate, circuit pattern and lines and/or shapes of flexible dielectric material.

7. A flexible printed circuit comprising a substrate with a conductor circuit pattern **characterized by** lines and/or shapes of flexible dielectric material over the substrate at predetermined locations between the conductor lines or shapes of the circuit pattern, said flexible dielectric material having a greater elasticity than said circuit pattern.

8. A method for manufacturing a flexible electrode, wherein a pad of conductive material and of desired shape is formed on a substrate, **characterized in that** said pad is reinforced by forming lines and/or shapes of flexible dielectric material at predetermined locations on said substrate and/or on said pad, said flexible dielectric material having a greater elasticity than said conductive pad.

9. The method according to claim 8, wherein said lines and/or shapes of flexible dielectric material are formed on said substrate.

10. The method according to claim 9, wherein said conductive pad is formed over the lines and/or shapes of said flexible dielectric material.

11. The method according to claim 8, wherein said lines and/or shapes of flexible dielectric material are formed in regions of said pad where the conductive material has been removed down to the underlying substrate.

12. The method according to claim 8, wherein said flexible dielectric material is printed on said substrate by a printing technique such as screen, inkjet, flexo, gravure or offset printing.

13. A flexible electrode comprising a pad of conductive material on a substrate, **characterized by** lines and/or shapes of flexible dielectric material at predetermined locations on said substrate and/or on said pad, said flexible dielectric material having a greater elasticity than said conductive pad.

14. The method according to any one of claims 1 to 6 and 8 to 12, wherein said dielectric material has a Young's modulus between 300 and 4 000 MPa.
